(19) Europäisches Patentamt
European Patent Office
Office européen des brevets

(11) **EP 2 824 464 B1**

(12) **EUROPÄISCHE PATENTSCHRIFT**

(45) Veröffentlichungstag und Bekanntmachung des Hinweises auf die Patenterteilung:
**08.08.2018   Patentblatt 2018/32**

(51) Int Cl.:
*G01R 19/00* *(2006.01)*      *G01R 35/00* *(2006.01)*

(21) Anmeldenummer: **14166947.3**

(22) Anmeldetag: **05.05.2014**

(54) **Verfahren und Vorrichtung zur Strommessung an einem Umrichter**

Method and device for measuring currents in a converter

Procédé et dispositif destinés à mesurer le courant dans un convertisseur

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **10.07.2013   DE 102013213508**

(43) Veröffentlichungstag der Anmeldung:
**14.01.2015   Patentblatt 2015/03**

(73) Patentinhaber: **Dr. Johannes Heidenhain GmbH 83301 Traunreut (DE)**

(72) Erfinder: **Brendel, Christian 83301 Traunreut (DE)**

(56) Entgegenhaltungen:
EP-A1- 2 607 914        WO-A1-2010/045965
WO-A2-2012/117275       DE-A1- 10 240 243
JP-A- 2005 160 136      US-A1- 2006 181 289

**Beschreibung**

Die Erfindung betrifft ein Verfahren zur Strommessung an einem Umrichter nach dem Oberbegriff des Anspruchs 1 sowie eine hierfür vorgesehene Vorrichtung nach dem Oberbegriff des Anspruchs 12. Hierbei wird an den Ausgängen des Umrichters von Strommesseinrichtungen der jeweilige Phasenstrom gemessen, um diesen einer dem Umrichter zugeordneten Steuer- oder Regeleinrichtung zuführen zu können.

Über einen Umrichter, an dessen Ausgängen vorliegend die Phasenströme gemessen werden sollen, kann z.B. ein Elektromotor betrieben werden, welcher derart angesteuert wird, dass mit einer dem Elektromotor zugeordneten Werkzeugmaschine oder anderen industriellen Installationen eine bestimmte, vorgegebene Sollwertposition erreicht wird. Hierfür ist der Elektromotor (an jeder seiner Phasen) derart mit Strom zu versorgen, dass der Versorgungsstrom mit dem zum Erreichen der Sollwertposition erforderlichen Soll-Strom korrespondiert. Dies erfordert wiederum eine hochgenaue Messung der einzelnen Phasenströme an den Ausgängen des Umrichters, über den der Elektromotor betrieben wird, um die Phasenströme so einstellen zu können, dass deren Ist-Werte dem jeweiligen Sollwert des Phasenstromes entsprechen.

Für eine ausführliche Diskussion dieser Problematik sei auf die WO 2012/028 390 A2 verwiesen, wo diesbezüglich ein bestimmtes Zusammenwirken zwischen Mitteln zum Messen der Phasenströme eines Elektromotors und weiteren Komponenten der Regelschaltung eines Elektromotors angegeben ist.

Aus der JP 2005160136 A ist ein Verfahren zur Strommessung an einem Umrichter bekannt, bei dem ein Phasenstrom von zwei Strommesseinrichtungen gemessen wird. Durch einen Vergleich der beiden Messungen kann ein defekter Sensor erkannt werden.

Aus der US 2006/0181289 A1 ist ein Schaltung bekannt, die der Strommessung anhand eines Spannungsabfalls über einem Widerstand dient.

Aus der WO 2012/117275 A2 ist ein Verfahren zur Strommessung bekannt, welches mittels zweier getrennter Strommesseinrichtungen eine genauere Strommessung durch Mittelung der Ergebnisse vorsieht und außerdem eine Kalibrierung während des Messbetriebs ermöglicht, indem die einzelnen Strommesseinrichtungen alternierend messen beziehungsweise eine Kalibrierung durchführen.

Schließlich ist es aus der DE 10240243 A1 bekannt, die Nullpunktdrift von Stromsensoren zu korrigieren. Hierbei kommen je zwei Stromsensoren mit unterschiedlicher Empfindlichkeit zum Einsatz, so dass je nach Größe des Stromes auf einen geeigneten Sensor umgeschaltet werden kann. Die Sensoren selbst sind aber hinsichtlich ihres Messbereichs nicht umschaltbar, so dass eine Nullpunktdrift nur in bestimmten Betriebszuständen korrigiert werden kann. Für eine hochgenaue Strommessung kann dies nachteilig sein, wenn dieser Betriebszustand nicht oder nicht oft genug auftritt.

Der Erfindung liegt das Problem zugrunde, mit einfachen Mitteln eine hochgenaue Strommessung an den Ausgängen eines Umrichters zu ermöglichen.

Dieses Problem wird hinsichtlich des Verfahrens durch die Merkmale des Anspruchs 1 gelöst.

Danach wird der jeweilige, an einem Ausgang des Umrichters zu ermittelnde Phasenstrom unabhängig an mindestens zwei, insbesondere genau zwei Strommesseinrichtungen gemessen, die insbesondere parallel zueinander angeordnet sind, wobei zur Bestimmung des jeweiligen Phasenstromes die Messergebnisse beider (aller) Strommesseinrichtungen herangezogen werden. Dies kann beispielsweise in der Weise erfolgen, dass die an den Strommesseinrichtungen gewonnenen Messwerte des Phasenstromes (gegebenenfalls gewichtet) gemittelt werden.

Durch die Bestimmung der Phasenströme aufgrund der Messwerte (mindestens) zweier Strommesseinrichtungen, insbesondere durch Mittelung der an den Strommesseinrichtungen für den jeweiligen Phasenstrom gewonnenen Messwerte, lässt sich das Signal-Rausch-Verhältnis des aus der Mittelung oder sonstigen Verarbeitung der einzelnen Strommesswerte resultierenden Ergebnisses für den jeweiligen Phasenstrom erhöhen, was zu einer erhöhten Präzision bei der Bestimmung der Phasenströme führt.

Das erfindungsgemäße Verfahren kann grundsätzlich bei beliebigen Mehrphasensystemen angewandt werden. Es ist insbesondere geeignet zur Anwendung bei dem in der Praxis häufigsten Fall, nämlich einem Dreiphasensystem.

Bevorzugt sind die mindestens zwei Strommesseinrichtungen aus den gleichen Komponenten aufgebaut und greifen in derselben Weise auf den jeweils zu messenden Phasenstrom zu, so dass der zu messende Phasenstrom in einfacher Weise durch Mittelung der an den einzelnen Strommesseinrichtungen hierfür gewonnenen Messwerte bestimmt werden kann.

Zur Strommessung mittels einer jeweiligen Strommesseinrichtung kann insbesondere eine Messspannung verarbeitet werden, die in Abhängigkeit von dem jeweils zu messenden Phasenstrom an einem der Strommesseinrichtung zugeordneten (im Strompfad liegenden) Widerstand abfällt. Eine Strommessung durch Verarbeitung einer Messspannung, die in Abhängigkeit von dem am jeweiligen Ausgang des Umrichters fließenden Strom an einem Widerstand der Strommesseinrichtung (sogenannter "Shunt-Widerstand" bzw. Messwiderstand) abfällt, wird z. B. in der DE 102 37 920 B3 beschrieben.

Mit der hochpräzisen Strommessung soll es insbesondere auch ermöglicht werden, sogenannte Offset- und/oder Verstärkungsabweichungen sehr genau zu ermitteln. Ein Offset-Fehler liegt vor, wenn der von einer Strommesseinrichtung gemessene Wert gegenüber dem tatsächlichen Strom um einen bestimmten Betrag (= Offset) verschoben ist. Und eine Verstärkungsabweichung liegt vor, wenn der Verstärkungsfaktor einer Strommesseinrichtung von dem Sollfaktor abweicht.

Zur Berücksichtigung derartiger Offset- und Verstärkungsabweichungen werden die Strommesseinrichtungen kalibriert. Zur Kalibrierung einer jeweiligen Strommesseinrichtung kann eine Kalibrierspannung genutzt werden, die separat von der Messspannung erzeugt wird, welche in Abhängigkeit von dem jeweils zu messenden Phasenstrom an einem der Strommesseinrichtung zugeordneten Widerstand abfällt. Hierzu können einer jeweiligen Strommesseinrichtung Umschaltmittel, z. B. in Form von Schaltern oder in Form eines Multiplexers, zugeordnet sein, mittels derer wahlweise die Messspannung oder die Kalibrierspannung einer Verarbeitung in der Strommesseinrichtung zugeführt wird.

Ein Messfehler in Form eines Offset-Fehlers lässt sich sehr einfach dadurch bestimmen, dass die Kalibrierspannung auf einen definierten Wert, insbesondere gleich Null, gesetzt und sodann ermittelt wird, ob eine durch Verarbeitung der Kalibrierspannung in der Strommesseinrichtung erzeugte resultierende Spannung einen von dem vorgegebenen Spannungswert, insbesondere vor dem Spannungswert Null, verschiedenen Wert hat. Dies weist auf einen Offset-Fehler hin, der entsprechend zu kompensieren ist.

Zur Bestimmung eines Messfehlers in Form einer sogenannten Verstärkungsabweichung (Verstärkungsfehler), also einer Abweichung des Verstärkungsfaktors in einer jeweiligen Strommesseinrichtung vom Sollfaktor, wird vorteilhaft eine (definierte) Kalibrierspannung mit einem Wert ungleich Null vorgegeben. Insbesondere wenn zuvor ein möglicher Offset-Fehler bereits ermittelt und kompensiert bzw. korrigiert worden ist, lässt sich dann der tatsächliche Verstärkungsfaktor in einfacher Weise als Quotient aus der an der Strommesseinrichtung ermittelten Spannung und der Kalibrierspannung bestimmen und so eine Abweichung vom Sollwert des Verstärkungsfaktors ermitteln und korrigieren bzw. kompensieren.

Weiter ist zu berücksichtigen, dass die Offset- und Verstärkungsabweichungen einer Strommesseinrichtung sich mit der Zeit ändern können, es also nicht genügt, zur Kompensation bzw. Korrektur derartiger Fehler eine Strommesseinrichtung lediglich einmalig vor bzw. bei Inbetriebnahme zu kalibrieren. So können äußere Einflüsse, wie z. B. die Temperatur, zu einer Änderung von Offset- und Verstärkungsabweichungen führen. Es ist daher zweckmäßig, eine jeweilige Strommesseinrichtung wiederkehrend (z. B. zu bestimmten, vorgebbaren Zeitpunkten) zu kalibrieren, so dass auch im Messbetrieb eine (laufende, wiederkehrende) Kompensation bzw. Korrektur von Messfehlern, insbesondere von Offset-und Verstärkungsabweichungen, an den einzelnen Strommesseinrichtungen möglich ist.

Vorliegend ist es in einfacher Weise möglich, eine Kalibrierung der Strommesseinrichtungen im laufenden Messbetrieb vorzunehmen, und zwar insbesondere bei fortlaufender Bereitstellung von Messwerten für die einzelnen Phasenströme an den Ausgängen des Umrichters. Da einem jeweiligen Ausgang des Umrichters zur Ermittlung des zugehörigen Phasenstromes mindestens zwei Strommesseinrichtungen zugeordnet sind, die den Phasenstrom unabhängig voneinander (in separaten Kanälen) bestimmen, können die einem jeweiligen Ausgang des Umrichters zur Messung des dortigen Phasenstromes zugeordneten Strommesseinrichtungen abwechselnd kalibriert werden. D. h., während eine der Strommesseinrichtungen kalibriert wird, und hierzu beispielsweise mit einer Kalibrierspannung beaufschlagt wird, misst mindestens eine andere, demselben Ausgang des Umrichters und damit demselben Phasenstrom zugeordnete Strommesseinrichtung weiterhin den aktuell anliegenden Phasenstrom.

Die typische Dauer eines Kalibriervorganges der hier maßgeblichen Art beträgt ca. 1 ms. Der zeitliche Abstand aufeinander folgender Kalibrierungen, um Änderungen äußerer Einflüsse, wie z. B. der Systemtemperatur, berücksichtigen zu können, liegt demgegenüber vorteilhaft in der Größenordnung von 1 s oder mehr.

Gemäß der Erfindung kann an den einzelnen Strommesseinrichtungen der Messbereich umgeschaltet werden, und zwar zwischen mindestens zwei unterschiedlichen Messbereichen. Hiermit lässt sich das Signal-Rausch-Verhältnis der Strommessung weiter verbessern. So geht es in bestimmten Anwendungen eines Umrichters, bei denen dieser zur Bestromung eines Elektromotors eingesetzt wird, darum, Objekte einerseits sehr schnell bewegen zu können, andererseits aber eine bestimmte Sollposition (Endposition) präzise zu erreichen. Dies ist beispielsweise der Fall bei Elektromotoren, die in sogenannten "Wafersteppern" eingesetzt werden. Für die schnelle Bewegung eines Objektes mittels des Umrichters und des zugeordneten Elektromotors müssen große Ströme präzise geregelt werden, während beim Erreichen der Endposition vergleichsweise kleinere Ströme hochgenau einzustellen sind. Hierfür kann es vorteilhaft sein, den Messbereich der Strommesseinrichtungen ändern zu können, um ihn gezielt an die Anforderungen einer jeweiligen Bewegungsphase anzupassen.

Hierzu ist es erforderlich, die Messbereichsumschaltung einer jeweiligen Strommesseinrichtung im laufenden Betrieb vornehmen zu können, und zwar insbesondere in der Weise, dass dies nicht zu einer Unterbrechung der Messung der einzelnen Phasenströme des Umrichters führt. Dies lässt sich erreichen, indem von den mindestens zwei einem jeweiligen Ausgang des Umrichters (und damit einem jeweiligen Phasenstrom) zugeordneten Strommesseinrichtungen zu einem bestimmten Zeitpunkt jeweils nur an einer eine Messbereichsumschaltung vorgenommen wird, während mindestens eine weitere Strommesseinrichtung weiterhin den am jeweiligen Ausgang des Umrichters anliegenden Phasenstrom misst.

Die Umschaltung des Messbereichs einer Strommesseinrichtung wird dadurch eingeleitet, dass zunächst die von dieser Strommesseinrichtung erzeugten Messdaten bei der Ermittlung des resultierenden Wertes für den Phasenstrom ignoriert werden und lediglich die auf jenen Phasenstrom bezogenen Messwerte der mindestens einen weiteren Strommesseinrichtung berücksichtigt werden. Sodann wird der Messbereich der erstgenannten Strommesseinrichtung umgeschaltet und die Einschwingzeit abgewartet. Erst dann werden auch die Messdaten dieser Strommesseinrichtung wieder bei der Ermittlung des resultierenden Phasenstromes berücksichtigt.

Bei korrekter Kalibrierung der Strommesseinrichtungen erfolgt das Umschalten des Messbereichs ohne einen erkennbaren Sprung in den Messdaten. Hierzu ist es vorteilhaft, die bei der Kalibrierung der Strommesseinrichtung verwendete Referenzspannung so zu wählen, dass sie für beide Messbereiche angewendet werden kann. D. h., die Kalibrierung einer jeweiligen Strommesseinrichtung erfolgt - sowohl bei Inbetriebnahme als auch im Messbetrieb - jeweils unter Verwendung der gleichen Referenzspannungen in den unterschiedlichen Messbereichen, insbesondere zwei Messbereichen. Hierfür wird die Referenzspannung vorteilhaft so gewählt, dass sie bezogen auf den vergleichsweise empfindlichsten (kleinsten) Messbereich in der Nähe von dessen Bereichsgrenze liegt.

Nach erfolgter Umschaltung einer Strommesseinrichtung kann sodann in entsprechender Weise der Messbereich der mindestens einen weiteren Strommesseinrichtung umgeschaltet werden, die demselben Ausgang des Umrichters und damit dem entsprechenden Phasenstrom zugeordnet ist.

Eine Vorrichtung zur Strommessung an einem Umrichter, die insbesondere auch zur Ausführung des erfindungsgemäßen Verfahrens geeignet ist, ist durch die Merkmale des Anspruchs 12 charakterisiert. Vorteilhafte Weiterbildungen der Vorrichtung ergeben sich aus den von Anspruch 12 abhängigen Ansprüchen.

Weitere Einzelheiten und Vorteile der Erfindung werden bei der nachfolgenden Beschreibung von Ausführungsbeispielen anhand der Figuren deutlich werden.

Es zeigen:

Fig. 1   einen Umrichter mit einer Mehrzahl Ausgängen zum Betrieb eines Motors, an dessen Ausgängen jeweils Mittel zur Strommessung vorgesehen sind;

Fig. 2   einen möglichen Aufbau der Mittel zur Strommessung aus Figur 1;

Fig. 3   eine schematische Darstellung unterschiedlicher Messbereiche der Mittel zur Strommessung;

Fig. 4   eine Abwandlung der Anordnung aus Figur 2.

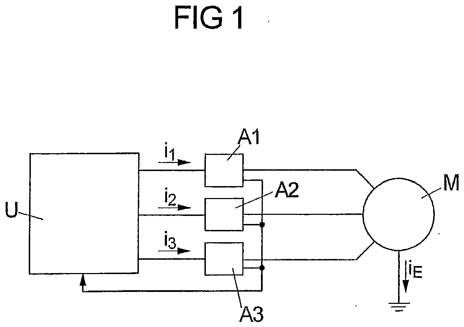

In Figur 1 ist ein Umrichter U dargestellt, der eine Mehrzahl Ausgänge ("Phasenausgänge") aufweist, an denen im Betrieb des Umrichters jeweils ein Strom $i_1$, $i_2$, $i_3$ ("Phasenstrom") fließt. Im Ausführungsbeispiel handelt es sich um ein sogenanntes dreiphasiges System mit drei Ausgängen des Umrichters U und dementsprechend drei Ausgangs- bzw. Phasenströmen $i_1$, $i_2$ und $i_3$. Der Umrichter U dient hier zum Betrieb eines Elektromotors M, dem die an den Ausgängen des Umrichters U anliegenden Ströme $i_1$, $i_2$, $i_3$ zugeführt werden.

Weiterhin sind an den Ausgängen des Umrichters U jeweils Mittel zur Strommessung $A_1$, $A_2$, $A_3$ angeordnet, mit denen der am jeweiligen Ausgang anliegende Strom $i_1$, $i_2$, $i_3$ ermittelbar ist. D. h., jeweilige Mittel zur Strommessung $A_1$, $A_2$ und $A_3$ dienen jeweils zur Ermittlung des vom zugehörigen Ausgang des Umrichters U zum Elektromotor M fließenden Stromes $i_1$, $i_2$ bzw. $i_3$.

Die von den Mitteln zur Strommessung $A_1$, $A_2$ und $A_3$ ermittelten Ströme können einer dem Umrichter U zugeordneten, vorliegend z. B. in den Umrichter U integrierten, Regeleinrichtung zugeführt werden, um hiermit die an den Ausgängen des Umrichters U anliegenden Ströme $i_1$, $i_2$ und $i_3$ regeln zu können. Die Summe der drei Phasenströme $i_1$, $i_2$, $i_3$ sollte dabei stets Null ergeben, da ansonsten ein unerwünschter Strom $i_E$ gegen Erde fließt. Diese Bedingung kann zur Fehlererkennung herangezogen werden.

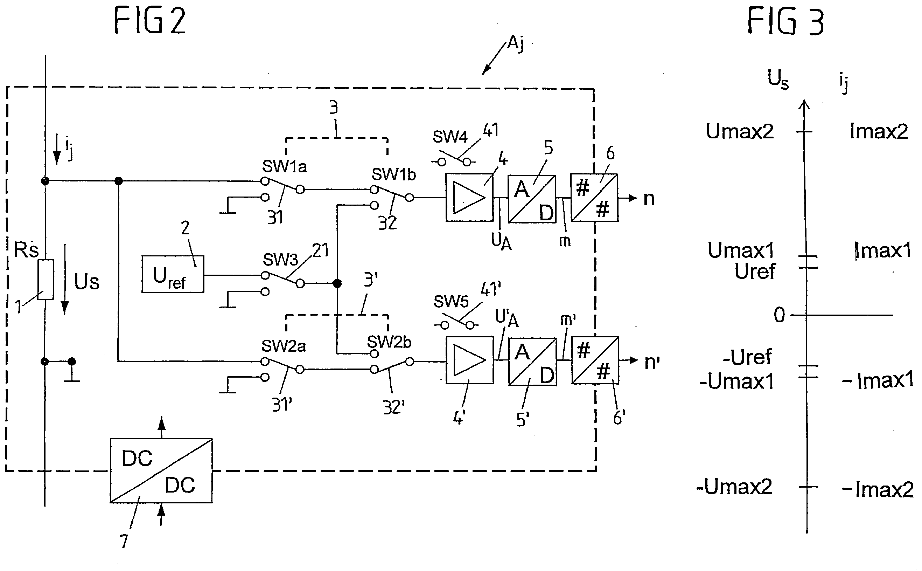

Ein möglicher Aufbau der Mittel zur Strommessung $A_1$, $A_2$ und $A_3$ ist in Figur 2 beispielhaft anhand eines Mittels zur Strommessung $A_j$ dargestellt, das zur Ermittlung des Phasenstromes $i_j$ an einem der Ausgänge des Umrichters U dient. Die Mittel zur Strommessung $A_j$ umfassen einen Widerstand 1 (Mess- bzw. Shunt-Widerstand $R_S$, z. B. mit einem typischen Wert zwischen 100 $\mu\Omega$ und 100 m$\Omega$), an dem eine von dem jeweils zu messenden Strom $i_j$ abhängige Messspannung $U_S$ abgegriffen werden kann. Diese wird mittels eines Verstärkers 4 verstärkt und als resultierender (analoger) Spannungswert $U_A$ einem Analog-Digital-Umsetzer 5 zugeführt. Die hinter dem Analog-Digital-Umsetzer 5 anliegenden digitalen Spannungssignale m repräsentieren als Messwerte der Strommesseinrichtung 4, 5 den zu messenden Strom $i_j$ ("Strommessung"). Das Prinzip einer solchen Strommesseinrichtung ist beispielsweise in der DE 102 37 920 B3 beschrieben.

Vorliegend beschränken sich die Mittel $A_j$ zur Ermittlung eines jeweiligen Phasenstromes $i_j$ jedoch nicht auf die Messung jenes Stromes $i_j$ mittels einer Strommesseinrichtung 4, 5, sondern hierzu wird zusätzlich auch eine zweite, separat arbeitende Strommesseinrichtung 4', 5' verwendet. Diese zusätzliche Strommesseinrichtung 4', 5' weist im Ausführungsbeispiel den gleichen Aufbau auf und basiert auf baugleichen Komponenten wie die erstgenannte Strommesseinrichtung 4, 5.

Die zweite Strommesseinrichtung 4', 5' zur Ermittlung des Stromes $i_j$ greift im Ausführungsbeispiel ebenfalls die an dem Widerstand 1 abfallende Messspannung $U_S$ ab, welche sodann mittels eines Verstärkers 4' verstärkt und als resultierender (analoger) Spannungswert $U_A$' einem Analog-Digital-Umsetzer 5' zugeführt wird. Die hinter dem Analog-Digital-Umsetzer 5' anliegenden digitalen Spannungsmesswerte m' repräsentieren als Messwerte der Strommesseinrichtung 4', 5' ebenfalls den zu messenden Strom $i_j$.

Die beiden zur Bestimmung ein und desselben Phasenstromes $i_j$ dienenden Strommesseinrichtungen 4, 5 und 4', 5' sind parallel zueinander geschaltet. Sie greifen auf dieselbe Messspannung $U_R$ des Widerstandes 1 zu und liefern somit zwei unabhängige Messwerte $U_A$, $U_A$' bzw. m, m', welche die von dem zu messenden Strom $i_j$ abhängige Messspannung $U_R$ repräsentieren.

Durch Mittelung der von den Strommesseinrichtungen 4, 5; 4', 5' gewonnenen Messergebnisse lässt sich ein resultierender Wert für den Strom $i_j$ ermitteln, und zwar mit einem verbesserten Signal-Rausch-Verhältnis verglichen mit der Bestimmung des Stromes $i_j$ unter Verwendung nur einer Strommesseinrichtung 4, 5.

Das Potential der Strommesseinrichtungen 4, 5; 4', 5' ist bezogen auf den Widerstand 1. Um die Potentialdifferenz zu einer nachgeordneten Steuerschaltung zu überwinden, über die mittels des Umrichters U beispielsweise ein Motor betrieben werden soll und deren Potential regelmäßig auf das Erdpotential bezogen ist, können Signalkoppler 6, 6' und DC-DC-Wandler 7 genutzt werden. Hierdurch lassen sich entsprechend korrigierte (digitale) Ausgangswerte n, n' der Strommesseinrichtungen 4, 5; 4', 5' bezogen auf Erdpotential erzeugen.

Zusammenfassend weisen die jeweiligen Mittel $A_j$ zur Bestimmung des Phasenstromes $i_j$ an einem Ausgang des Umrichters U jeweils zwei Strommesseinrichtungen 4, 5; 4', 5' auf, die unabhängig voneinander den Strom $i_j$ messen, und zwar durch Verarbeitung derselben Messspannung $U_R$, welche von dem zu messenden Strom $i_j$ abhängt. Aus den Messwerten der beiden Strommesseinrichtungen 4, 5; 4', 5' kann sodann durch Mittelung ein resultierender Wert des Stromes $i_j$ ermittelt werden.

Im Betrieb solcher Mittel zur Strommessung kann es zu (systematischen) Messfehlern zum Beispiel dadurch kommen, dass sich der Verstärkungsfaktor $\alpha(t)$ und der Offset $\beta(t)$ in der jeweiligen Strommesseinrichtung 4, 5; 4', 5' zeitlich ändern. Die durch Kalibrierung zu kompensierenden bzw. korrigierenden Messwertabweichungen entstehen insbesondere in der Messkette vom Widerstand 1 über den jeweiligen Verstärker 4, 4' zum Digital-Analog-Umsetzer 5, 5'. Hierbei handelt es sich überwiegend um Offset- und Verstärkungsabweichungen des jeweiligen Verstärkers 4, 4' sowie des jeweiligen Analog-Digital-Umsetzers 5, 5'.

Es gilt dabei:

$$U_A = U_S \cdot \alpha(t) + \beta(t).$$

Somit ist es erforderlich, die Strommesseinrichtungen 4, 5; 4', 5' (regelmäßig) zu kalibrieren, um Messfehler in Form von (zeitlich veränderlichen) Messwertabweichungen von den wahren Werten (für die zu messenden Ströme) zu kompensieren bzw. korrigieren zu können. Zur Kalibrierung sind dem Verstärker 4 bzw. 4' einer jeweiligen Strommesseinrichtung 4, 5; 4', 5' Umschaltmittel 3, 3' vorgeschaltet, über die dem Verstärker wahlweise die am Widerstand 1 abgegriffene Messspannung $U_S$ oder eine Kalibrierspannung $U_K$ zugeführt werden kann, um hieraus zunächst durch Verstärkung eine Spannung $U_A$ bzw. $U_A$' und anschließend den entsprechenden digitalen Messwert m bzw. m' zu erzeugen.

Vorliegend werden die Umschaltmittel 3, 3' jeweils gebildet durch zwei Schalter 31, 32 bzw. 31', 32', in Abhängigkeit von deren Schaltposition entweder die Messspannung $U_S$ oder eine Kalibrierspannung $U_K$ am Verstärker 4, 4' der jeweiligen Strommesseinrichtung 4, 5 bzw. 4', 5' anliegt. Grundsätzlich wäre zur Umschaltung ein einzelner Schalter 32 bzw. 32' der jeweiligen Umschaltmittel 3, 3' ausreichend. Durch die Reihenschaltung zweier Schalter 31, 32 bzw. 31', 32' in den jeweiligen Umschaltmitteln 3, 3' lässt sich jedoch ein Signaldurchgriff deutlich verringern, was für eine Präzisionsmessung vorteilhaft ist.

Mittels eines weiteren Schalters 21 kann die Kalibrierspannung $U_K$ entweder über eine Kalibrierquelle 2 auf einen Referenzwert $U_{ref}$ oder auf Masse und damit den Wert 0V gesetzt werden.

Die Kalibrierung der Strommesseinrichtungen 4, 5; 4', 5' wird nachfolgend (zur Vereinfachung der Notation) beispielhaft anhand der einen Strommesseinrichtung 4, 5 beschrieben werden; sie gilt jedoch in gleicher Weise für die andere Strommesseinrichtung 4', 5'. Hierzu müssen bei den nachfolgenden Betrachtungen jeweils lediglich die Bezugszeichen und Messwerte durch ein " ' " ergänzt werden.

Zur Bestimmung einer Messwertabweichung in Form eines Offsets wird mittels der Kalibrierquelle 2 eine Kalibrierspannung $U_K$ mit einem bestimmten, vorgebbaren Wert erzeugt, z. B. mit dem Wert $U_K = 0V$. Diese Kalibrierspannung $U_K$ (z. B. mit dem Wert 0V) wird über die Umschaltmittel 3, 21 (anstelle der Messspannung $U_S$) auf den Eingang des Verstärkers 4 gegeben.

Aus dem obigen Zusammenhang $U_A = U_K \cdot \alpha(t) + \beta(t)$ folgt für den Fall $U_K = 0$:

$$U_A = \beta(t).$$

Somit ist der aktuelle (im Allgemeinen zeitabhängige) Wert des Offsets $\beta(t)$ ermittelt als das aktuell am Ausgang des Verstärkers V anliegende (analoge) Spannungssignal $U_A$ bzw. als entsprechender Digitalwert m.

Dies ermöglicht eine Kompensation bzw. Korrektur von Offset-Fehlern, indem von dem an der entsprechenden Strommesseinrichtung 4, 5 bei der Strommessung jeweils ermittelten Spannungswert $U_A$ der zuvor ermittelte Offset $\beta(t)$ abgezogen wird. Es liegt dann in dem hinter dem Verstärker V anliegenden Spannungswert $U_A$ kein relevanter Offset mehr vor, so dass $U_A$ nunmehr gegeben ist als $U_A = U_K \cdot \alpha(t)$.

Wird nun in einer weiteren (zweiten) Messung eine Kalibrierspannung $U_K$ mit einem von Null verschiedenen Referenzwert $U_{ref}$ herangezogen ($U_K = U_{ref}$), so gilt: $U_A = U_{ref} \cdot \alpha(t)$. Hieraus lässt sich der Momentanwert des Verstärkungsfaktors $\alpha(t)$ sofort bestimmen als

$$\alpha(t) = \frac{U_A}{U_{ref}}.$$

Mit nur zwei Messungen können also im Kalibrierbetrieb einer Strommesseinrichtung Aj unter Verwendung jeweils einer definierten Kalibrierspannung $U_K$, die vorliegend beispielhaft für die erste Messung gleich Null gesetzt wird und für die zweite Messung auf einen von Null verschiedenen Wert $U_{ref}$ gesetzt wird, der zeitabhängige Offset $\beta(t)$ sowie die zeitabhängige Abweichung des Verstärkungsfaktors $\alpha(t)$ bestimmt und anschließend bei der Ermittlung der (analogen) Spannungsmesswerte $U_A$ bzw. der entsprechenden digitalen Werte n berücksichtigt, also kompensiert bzw. korrigiert werden.

Die Verwendung zweier unabhängiger (parallel geschalteter) Strommesseinrichtungen 4, 5; 4', 5' zur Ermittlung eines jeweiligen Phasenstromes $i_j$ an den Ausgängen des Umrichters U ermöglicht dabei eine problemlose Kalibrierung der Strommesseinrichtungen nicht nur vor bzw. bei Inbetriebnahme sondern insbesondere auch im laufenden Messbetrieb, und zwar ohne dessen Unterbrechung. Dies ist deshalb von Bedeutung, weil eine einmalige Kompensation bzw. Korrektur von Offset- und Verstärkungsabweichungen vor Inbetriebnahme des Systems, jedenfalls dann wenn hochpräzise Strommessungen verlangt werden, nicht ausreichend ist. Denn die Offset- und Verstärkungsabweichungen können sich mit der Zeit ändern, z. B. in Abhängigkeit von sich ändernden Umgebungsbedingungen, wie der Temperatur. Daher ist eine wiederkehrende Neukalibrierung der Strommesseinrichtungen, insbesondere in vorgegebenen zeitlichen Abständen, etwa im Bereich von 1 s, vorteilhaft.

Vorliegend kann die Kalibrierung einer jeweiligen Strommesseinrichtung 4, 5 oder 4', 5' in einfacher Weise im laufenden Messbetrieb vorgenommen werden, indem abwechselnd jeweils nur eine der beiden Strommesseinrichtungen 4, 5 oder 4', 5' kalibriert wird, welche der Messung desselben Phasenstromes $i_j$ dienen. D. h., während die eine Strommesseinrichtung 4, 5 kalibriert wird, misst die andere Strommesseinrichtung 4', 5' weiterhin den Strom $i_j$ und umgekehrt. Lediglich eine Mittelung der Messergebnisse kann während der Kalibrierung selbstverständlich nicht vorgenommen werden.

Die Dauer eines Kalibriervorganges beträgt typischerweise weniger als 1 ms. Dies sind drei Größenordnungen weniger als ein zweckmäßiger zeitlicher Abstand zwischen aufeinanderfolgenden Kalibrierungen, welcher bei etwa 1 s liegt. Damit ist im Messbetrieb die Kalibrierung einer der beiden Strommesseinrichtungen 4, 5; 4', 5' (zeitlich betrachtet) ein Ausnahmefall. Weit überwiegend stehen jeweils beide Strommesseinrichtungen 4, 5; 4', 5' zur Verfügung, um einen jeweiligen Phasenstrom $i_j$ durch Mittelung über die Messwerte beider Strommesseinrichtungen 4, 5 und 4', 5' zu bestimmen.

Auch während der Kalibrierung einer jeweiligen Strommesseinrichtung 4, 5 oder 4', 5' kann die Strommessung also fortgeführt werden; es entfällt lediglich die mit einer weiteren Erhöhung des Signal-Rausch-Verhältnisses verbundene Mittelung über zwei Messergebnisse.

Beim Ausführungsbeispiel der Figur 2 ist weiterhin eine Umschaltung zwischen verschiedenen Messbereichen einer jeweiligen Strommesseinrichtung 4, 5 bzw. 4', 5' vorgesehen, und zwar vorliegend konkret zwischen zwei Messbereichen. Diese Umschaltmöglichkeit dient einer weiteren Verbesserung des Signal-Rausch-Verhältnisses bei der Strommessung. So kann die Verwendung unterschiedlicher Messbereiche zur Strommessung zweckmäßig sein, wenn über den Umrichter U, an dessen Ausgängen die einzelnen Phasenströme gemessen werden sollen, ein Elektromotor angesteuert wird, mit dem bestimmte Objekte einerseits schnell bewegt und andererseits präzise in bestimmte Endpositionen überführt werden sollen. Während mit der schnellen Bewegung der Objekte das Erfordernis einer Regelung großer Ströme einhergeht, ist zum präzisen Erreichen vorgegebener Endpositionen eine hochgenaue Einstellung vergleichsweise kleiner Ströme notwendig. Durch eine Messbereichsumschaltung lassen sich die Strommesseinrichtungen an solch unterschiedliche Anforderungen anpassen.

Zur Umschaltung des Messbereichs einer jeweiligen Strommesseinrichtung 4, 5; 4', 5' ist vorliegend dem Verstärker 4 bzw. 4' der jeweiligen Strommesseinrichtung ein Schalter 41 bzw. 41' zugeordnet, mit dem sich dessen Verstärkung und damit im Ergebnis der Messbereich der jeweiligen Strommesseinrichtung 4, 5 bzw. 4', 5' umschalten lässt.

Zwei unterschiedliche Messbereiche einer Strommesseinrichtung sind in Figur 3 schematisch dargestellt, und zwar bezogen sowohl auf die gemessene Spannung U als auch bezogen auf den entsprechenden Strom I. Im ersten, kleineren Messbereich sind Spannungswerte zwischen $U_{max1}$ und $-U_{max1}$ bzw. entsprechende Stromwerte zwischen $I_{max1}$ und $-I_{max1}$ erfassbar. Im zweiten, größeren Messbereich liegen die Spannungswerte zwischen $U_{max2}$ und $-U_{max2}$ bzw. $I_{max2}$ und $-I_{max2}$.

Gemäß einem konkreten Beispiel kann etwa der Wert von $I_{max1} = 5.3$ A und der Wert von $I_{max2} = 38$ A betragen; dies entspricht Spannungen von 53 mV bzw. 380 mV bei einem Widerstand R von 10 m$\Omega$.

Die Anordnung aus Figur 2 ermöglicht dabei eine Umschaltung zwischen unterschiedlichen Messbereichen nicht nur vor bzw. bei Inbetriebnahme des Systems sondern auch im laufenden Messbetrieb, und zwar ohne Unterbrechung der Strommessung. Hierzu wird bei der Umschaltung des Messbereichs einer der beiden Strommesseinrichtungen 4, 5 oder 4', 5' wie folgt vorgegangen: Zunächst werden die Daten der umzuschaltenden Strommesseinrichtung (z.B. 4, 5) bei der Ermittlung des resultierenden Stromes ignoriert; d. h., die Ermittlung des resultierenden Stromes erfolgt nicht mehr durch Mittelung der Messwerte beider Strommesseinrichtungen 4, 5 und 4', 5', sondern es werden nur noch die Messwerte der aktuell nicht umzuschaltenden Strommesseinrichtung (z.B. 4', 5') herangezogen. Dann wird bei der hinsichtlich des Messbereichs einzustellenden Strommesseinrichtung die Verstärkung (mittels des hierfür vorgesehenen Schalters 41) umgeschaltet und die Einschwingzeit abgewartet. Erst dann werden die Messwerte der soeben umgeschalteten Strommesseinrichtung (4, 5) wieder zur Ermittlung des resultierenden Phasenstroms herangezogen.

Anschließend kann der Messbereich der anderen Strommesseinrichtung 4', 5' umgeschaltet werden, während nunmehr die eine Strommesseinrichtung 4, 5 weiterhin Messwerte für den zu ermittelnden Phasenstrom liefert.

Wird bei der Kalibrierung der Strommesseinrichtungen eine Referenzspannung $U_{ref}$ verwendet, die für beide Messbereiche gilt, also innerhalb des ersten, kleineren Messbereiches liegt, so entsteht beim Umschalten des Messbereiches einer jeweiligen Strommesseinrichtung 4, 5 bzw. 4', 5' kein Sprung in den Messdaten (obwohl eine Umschaltung der Verstärkung einer jeweiligen Strommesseinrichtung 4, 5 bzw. 4', 5' zu einer anderen Offset-Verschiebung führt).

Sobald beide Strommesseinrichtungen 4, 5 und 4', 5' in den gewünschten neuen Messbereich umgeschaltet worden sind, werden zur Ermittlung des resultierenden Phasenstromes wiederum die Strommesswerte beider Strommesseinrichtungen 4, 5 und 4', 5' gemittelt.

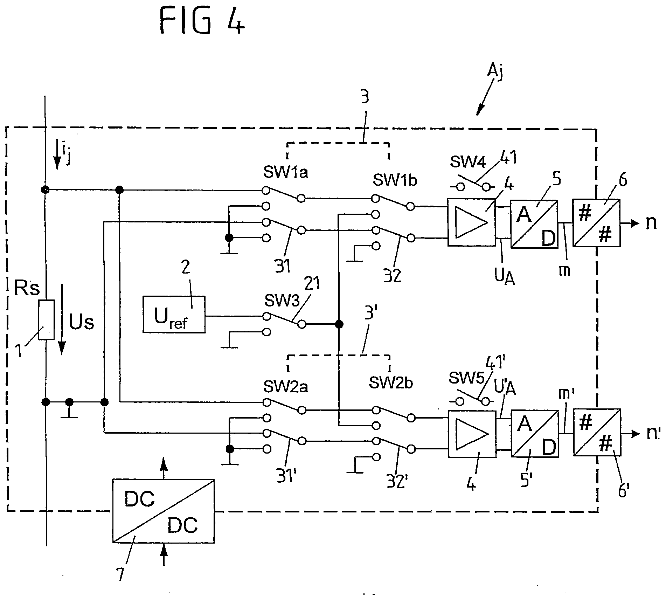

Bei einer sehr präzisen Strommessung kann ein Messfehler dadurch entstehen, dass das Bezugspotential nicht überall in der Schaltung exakt gleich ist. Deshalb kann eine differentielle Messung notwendig sein, denn für eine Differenzspannung spielt das Bezugspotential keine Rolle. Figur 4 zeigt daher eine Abwandlung des Ausführungsbeispieles aus Figur 2. Es besteht der Unterschied darin, dass die Anordnung aus Figur 4 auf der Grundlage einer differenziellen Signalführung arbeitet. D. h., von den Strommesseinrichtungen 4, 5 bzw. 4', 5' wird - im Unterschied zur Anordnung aus Figur 2 - nicht einfach die am Widerstand 1 abfallende Spannung $U_S$ abgegriffen, sondern vielmehr eine Differenz dieser Spannung, wie in Figur 4 dargestellt. Die Umschaltmittel 3, 3' sowie die Strommesseinrichtungen 4, 5 und 4', 5' sind vom Aufbau her an diese differenzielle Signalführung angepasst. Im Übrigen stimmt die Anordnung aus Figur 4 mit der Anordnung aus Figur 2 überein.

## Patentansprüche

1. Verfahren zur Strommessung an einem Umrichter, bei dem an den Ausgängen des Umrichters (U) von Strommesseinrichtungen der jeweilige Phasenstrom ($i_j$) bestimmt wird, um diesen einer dem Umrichter (U) zugeordneten Regeleinrichtung zuzuführen, wobei der jeweilige, an einem Ausgang des Umrichters (U) zu ermittelnde Phasenstrom ($i_j$) unabhängig von mindestens zwei Strommesseinrichtungen (4, 5; 4', 5') gemessen wird, wobei zur Bestimmung des jeweiligen Phasenstromes die Messergebnisse beider Strommesseinrichtungen (4, 5; 4', 5') herangezogen werden,
**dadurch gekennzeichnet,**
**dass** der Messbereich der Strommesseinrichtungen (4, 5; 4', 5') im Messbetrieb einstellbar ist, indem der Messbereich jeweils zwischen mindestens zwei vorgegebenen Messbereichen umschaltbar ist und dass der Messbereich von Strommesseinrichtungen (4, 5; 4', 5'), die den Phasenstrom ($i_j$) am selben Ausgang des Umrichters (U) messen, abwechselnd umgeschaltet wird, so dass während des Umschaltens des Messbereiches einer Strommesseinrichtung (4, 5) mindestens eine andere Strommesseinrichtung (4', 5') weiterhin den Phasenstrom ($i_j$) misst.

2. Verfahren nach Anspruch 1, **dadurch gekennzeichnet, dass** die Strommesseinrichtungen (4, 5; 4', 5'), an denen jeweils der eine Phasenstrom ($i_j$) gemessen wird, parallel zueinander geschaltet sind.

3. Verfahren nach Anspruch 1 oder 2, **dadurch gekennzeichnet, dass** zur Bestimmung des resultierenden Wertes des Phasenstromes ($i_j$) die Messwerte der Strommesseinrichtungen (4, 5; 4', 5') gemittelt werden.

4. Verfahren nach einem der vorhergehenden Ansprüche, **dadurch gekennzeichnet, dass** zur Strommessung mittels einer jeweiligen Strommesseinrichtung (4, 5; 4', 5') eine Messspannung ($U_S$) verarbeitet wird, die in Abhängigkeit von dem jeweils zu messenden Phasenstrom ($i_j$) an einem der Strommesseinrichtung (4, 5; 4', 5') zugeordneten Widerstand (1) abfällt.

5. Verfahren nach einem der vorhergehenden Ansprüche, **dadurch gekennzeichnet, dass** die einzelnen Strommesseinrichtungen (4, 5; 4', 5') im Betrieb des Umrichters (U) wiederkehrend kalibriert werden.

6. Verfahren nach Anspruch 5, **dadurch gekennzeichnet, dass** zur Korrektur von Messfehlern die zur Messung eines Phasenstromes ($i_j$) dienenden

Strommesseinrichtungen (4, 5; 4', 5') einzeln kalibriert werden, während sich mindestens eine weitere zur Messung des einen Phasenstromes ($i_j$) dienende Strommesseinrichtung im Messbetrieb befindet.

7. Verfahren nach Anspruch 5 oder 6, **dadurch gekennzeichnet, dass** als Messfehler eine Offset-Verschiebung und/oder ein Verstärkungsfehler der jeweiligen Strommesseinrichtung (4, 5; 4', 5') durch Kalibrierung korrigiert werden.

8. Verfahren nach einem der Ansprüche 5 bis 7, **dadurch gekennzeichnet, dass** eine jeweilige Strommesseinrichtung (4, 5; 4', 5') während ihrer Kalibrierung für die Strommessung deaktiviert ist, also keine Messwerte des zugehörigen Phasenstromes ($i_j$) ermittelt.

9. Verfahren nach Anspruch 4, **dadurch gekennzeichnet, dass** zur Kalibrierung einer jeweiligen Strommesseinrichtung (4, 5; 4', 5') eine Kalibrierspannung ($U_K$) verarbeitet wird, die separat von der Messspannung ($U_S$) erzeugt wird.

10. Verfahren nach Anspruch 9, **dadurch gekennzeichnet, dass** einer jeweiligen Strommesseinrichtung (4, 5; 4', 5') Umschaltmittel (3; 3') zugeordnet sind, mittels derer wahlweise die Messspannung ($U_S$) oder die Kalibrierspannung ($U_K$) einer Verarbeitung in der Strommesseinrichtung (4, 5; 4', 5') zugeführt wird.

11. Verfahren nach Anspruch 9, **dadurch gekennzeichnet, dass** beim Kalibrieren der Strommesseinrichtungen (4, 5; 4', 5') als Kalibrierspannung ($U_K$) eine Referenzspannung ($U_{ref}$) verwendet wird, die innerhalb sämtlicher für die Strommesseinrichtungen (4, 5; 4', 5') einstellbarer Messbereiche liegt.

12. Vorrichtung zur Strommessung an einem Umrichter, mit einer Mehrzahl Strommesseinrichtungen, die zur Messung des jeweiligen Phasenstromes ($i_1$, $i_2$, $i_3$) an je einen Ausgang des Umrichters (U) geschaltet sind, um anhand der gemessenen Phasenströme eine dem Umrichter (U) zugeordnete Regeleinrichtung zu betreiben, wobei hinter einen jeweiligen Ausgang des Umrichters (U) mindestens zwei Strommesseinrichtungen (4, 5; 4', 5') geschaltet sind, die unabhängig voneinander den zugehörigen Phasenstrom ($i_j$) messen, so dass zur Bestimmung des jeweiligen Phasenstromes die Messergebnisse beider Strommesseinrichtungen (4, 5; 4', 5') herangezogen werden,
**dadurch gekennzeichnet,**
**dass** der Messbereich der Strommesseinrichtungen (4, 5; 4', 5') im Messbetrieb einstellbar ist, indem der Messbereich jeweils zwischen mindestens zwei vorgegebenen Messbereichen umschaltbar ist und dass der Messbereich von Strommesseinrichtungen (4, 5; 4', 5'), die den Phasenstrom ($i_j$) am selben Ausgang des Umrichters (U) messen, abwechselnd umschaltbar ist, so dass während des Umschaltens des Messbereiches einer Strommesseinrichtung (4, 5) mindestens eine andere Strommesseinrichtung (4', 5') weiterhin den Phasenstrom ($i_j$) misst.

13. Vorrichtung nach Anspruch 12, **dadurch gekennzeichnet, dass** die Strommesseinrichtungen (4, 5; 4', 5'), an denen jeweils der eine Phasenstrom ($i_j$) gemessen wird, parallel zueinander geschaltet sind.

14. Vorrichtung nach Anspruch 12 oder 13, ausgebildet und vorgesehen zur Durchführung des Verfahrens nach einem der Ansprüche 1 bis 11.

## Claims

1. Method for current measurement at a converter, in which method the respective phase current ($i_j$) is determined at the outputs of the converter (U) by current measurement devices in order to feed said phase current to a control device associated with the converter (U), wherein the respective phase current ($i_j$) to be ascertained at an output of the converter (U) is measured independently of at least two current measurement devices (4, 5; 4', 5'), wherein the measurement results of the two current measurement devices (4, 5; 4', 5') are used for the determination of the respective phase current, **characterized in that** the measurement range of the current measurement devices (4, 5; 4', 5') during measurement operation can be set by virtue of the measurement range in each case being able to be switched over between at least two prescribed measurement ranges and **in that** the measurement range of current measurement devices (4, 5; 4', 5') that measure the phase current ($i_j$) at the same output of the converter (U) is switched over alternately so that at least one other current measurement device (4', 5') continues to measure the phase current ($i_j$) during the switchover of the measurement range of a current measurement device (4, 5).

2. Method according to Claim 1, **characterized in that** the current measurement devices (4, 5; 4', 5') at which in each case one phase current ($i_j$) is measured are connected in parallel with one another.

3. Method according to Claim 1 or 2, **characterized in that** the measurement values of the current measurement devices (4, 5; 4', 5') are averaged for the determination of the resulting value of the phase current ($i_j$).

4. Method according to one of the preceding claims, **characterized in that**, for the current measurement by means of a respective current measurement device (4, 5; 4', 5'), a measurement voltage ($U_S$) is processed, which measurement voltage is dropped across a resistor (1), which is associated with the current measurement device (4, 5; 4', 5'), depending on the phase current ($i_j$) to be measured in each case.

5. Method according to one of the preceding claims, **characterized in that** the individual current measurement devices (4, 5; 4', 5') are calibrated recurrently during operation of the converter (U).

6. Method according to Claim 5, **characterized in that**, for the correction of measurement errors, the current measurement devices (4, 5; 4', 5') serving for the measurement of a phase current ($i_j$) are calibrated individually, while at least one further current measurement device serving for measurement of one phase current ($i_j$) is in measurement operation.

7. Method according to Claim 5 or 6, **characterized in that** an offset shift and/or an amplification error of the respective current measurement device (4, 5; 4', 5') are corrected as measurement errors by calibration.

8. Method according to one of Claims 5 to 7, **characterized in that** a respective current measurement device (4, 5; 4', 5') is deactivated during calibration thereof for the current measurement, that is to say does not ascertain measurement values of the associated phase current ($i_j$).

9. Method according to Claim 4, **characterized in that** a calibration voltage ($U_K$), which is generated separately from the measurement voltage ($U_s$), is processed for the calibration of a respective current measurement device (4, 5; 4', 5').

10. Method according to Claim 9, **characterized in that** switchover means (3; 3') are associated with a respective current measurement device (4, 5; 4', 5'), which switchover means are used to selectively feed the measurement voltage ($U_S$) or the calibration voltage ($U_K$) to a processing system in the current measurement device (4, 5; 4', 5').

11. Method according to Claim 9, **characterized in that** a reference voltage ($U_{ref}$), which is located within all of the measurement ranges that can be set for the current measurement devices (4, 5; 4', 5'), is used as calibration voltage ($U_K$) in the calibration of the current measurement devices (4, 5; 4', 5').

12. Apparatus for current measurement at a converter, comprising a plurality of current measurement devices, which are each connected to an output of the converter (U) for the measurement of the respective phase current ($i_1$, $i_2$, $i_3$) in order to operate a control device associated with the converter (U) based on the measured phase currents, wherein at least two current measurement devices (4, 5; 4', 5'), which measure the associated phase current ($i_j$) independently of one another, are connected downstream of a respective output of the converter (U), so that the measurement results of the two current measurement devices (4, 5; 4', 5') are used for the determination of the respective phase current, **characterized in that** the measurement range of the current measurement devices (4, 5; 4', 5') during measurement operation can be set by virtue of the measurement range in each case being able to be switched over between at least two prescribed measurement ranges and **in that** the measurement range of current measurement devices (4, 5; 4', 5') that measure the phase current ($i_j$) at the same output of the converter (U) can be switched over alternately so that at least one other current measurement device (4', 5') continues to measure the phase current ($i_j$) during the switchover of the measurement range of a current measurement device (4, 5).

13. Apparatus according to Claim 12, **characterized in that** the current measurement devices (4, 5; 4', 5') at which in each case one phase current ($i_j$) is measured are connected in parallel with one another.

14. Apparatus according to Claim 12 or 13, designed and provided for carrying out the method according to one of Claims 1 to 11.

**Revendications**

1. Procédé de mesure de courant sur un convertisseur statique, selon lequel le courant de phase ($i_j$) respectif est déterminé par des dispositifs de mesure du courant au niveau des sorties du convertisseur statique (U), afin d'acheminer celui-ci à un dispositif de régulation associé au convertisseur statique (U), le courant de phase ($i_j$) respectif à déterminer au niveau d'une sortie du convertisseur statique (U) étant mesuré indépendamment par au moins deux dispositifs de mesure du courant (4, 5 ; 4', 5'), les résultats des mesures des deux dispositifs de mesure du courant (4, 5 ; 4', 5') étant utilisés pour la détermination du courant de phase respectif, **caractérisé en ce que** la plage de mesure des dispositifs de mesure du courant (4, 5 ; 4', 5') étant réglable dans le mode de mesure, en pouvant permuter la plage de mesure respectivement entre au moins deux plages de mesure prédéfinies, et **en ce que** la plage de mesure des dispositifs de mesure du courant (4, 5 ; 4', 5') qui mesurent le courant de phase ($i_j$) à la même

sortie du convertisseur statique (U) est permutée en alternance, de sorte que pendant la permutation de la plage de mesure d'un dispositif de mesure du courant (4, 5), au moins un autre dispositif de mesure du courant (4', 5') continue à mesurer le courant de phase ($i_j$).

2. Procédé selon la revendication 1, **caractérisé en ce que** les dispositifs de mesure du courant (4, 5 ; 4', 5') au niveau desquels est respectivement mesuré ledit courant de phase ($i_j$) sont branchés en parallèle l'un à l'autre.

3. Procédé selon la revendication 1 ou 2, **caractérisé en ce que** la moyenne des valeurs mesurées des dispositifs de mesure du courant (4, 5 ; 4', 5') est calculée en vue de déterminer la valeur résultante du courant de phase ($i_j$).

4. Procédé selon l'une des revendications précédentes, **caractérisé en ce que** la mesure du courant au moyen d'un dispositif de mesure du courant (4, 5 ; 4', 5') respectif s'effectue en traitant une tension de mesure ($U_S$) qui chute aux bornes d'une résistance (1) associée au dispositif de mesure du courant (4, 5 ; 4', 5') en fonction du courant de phase ($i_j$) respectif à mesurer.

5. Procédé selon l'une des revendications précédentes, **caractérisé en ce que** les dispositifs de mesure du courant (4, 5 ; 4', 5') individuels sont étalonnés périodiquement lors du fonctionnement du convertisseur statique (U).

6. Procédé selon la revendication 5, **caractérisé en ce que** pour la correction des erreurs de mesure, les dispositifs de mesure du courant (4, 5 ; 4', 5') servant à la mesure d'un courant de phase ($i_j$) sont étalonnés individuellement pendant qu'au moins un dispositif de mesure du courant supplémentaire servant à la mesure dudit courant de phase ($i_j$) se trouve dans le mode de mesure.

7. Procédé selon la revendication 5 ou 6, **caractérisé en ce que** l'erreur de mesure corrigée par étalonnage est un déplacement par décalage et/ou un défaut d'amplification du dispositif de mesure du courant (4, 5 ; 4', 5') respectif.

8. Procédé selon l'une des revendications 5 à 7, **caractérisé en ce qu'**un dispositif de mesure du courant (4, 5 ; 4', 5') respectif est désactivé pour la mesure du courant pendant son étalonnage, c'est-à-dire qu'il ne détermine aucune valeur mesurée du courant de phase ($i_j$) associé.

9. Procédé selon la revendication 4, **caractérisé en ce que** l'étalonnage d'un dispositif de mesure du courant (4, 5 ; 4', 5') respectif s'effectue en traitant une tension d'étalonnage ($U_K$) qui est générée séparément de la tension de mesure (Us).

10. Procédé selon la revendication 9, **caractérisé en ce que** des moyens de permutation (3 ; 3') sont associés à un dispositif de mesure du courant (4, 5 ; 4', 5') respectif, au moyen desquels la tension de mesure ($U_S$) ou, au choix, la tension d'étalonnage ($U_K$) est acheminée à un traitement dans le dispositif de mesure du courant (4, 5 ; 4', 5').

11. Procédé selon la revendication 9, **caractérisé en ce que** lors de l'étalonnage des dispositifs de mesure du courant (4, 5 ; 4', 5'), la tension d'étalonnage ($U_K$) utilisée est une tension de référence ($U_{ref}$) qui est incluse dans toutes les plages de mesure réglables pour les dispositifs de mesure du courant (4, 5 ; 4', 5').

12. Arrangement servant à la mesure de courant sur un convertisseur statique, comprenant une pluralité de dispositifs de mesure du courant qui sont respectivement connectés à une sortie du convertisseur statique (U) pour la mesure du courant de phase ($i_1$, $i_2$, $i_3$,) respectif, en vue de faire fonctionner un dispositif de régulation associé au convertisseur statique (U) à l'aide des courants de phase mesurés, au moins deux dispositifs de mesure du courant (4, 5 ; 4', 5') étant connectés derrière une sortie respective du convertisseur statique (U), lesquels mesurent le courant de phase ($i_j$) associé indépendamment l'un de l'autre, de sorte que les résultats des mesures des deux dispositifs de mesure du courant (4, 5 ; 4', 5') sont utilisés pour la détermination du courant de phase respectif,
**caractérisé**
**en ce que** la plage de mesure des dispositifs de mesure du courant (4, 5 ; 4', 5') est réglable dans le mode de mesure, en pouvant permuter la plage de mesure respectivement entre au moins deux plages de mesure prédéfinies, et **en ce que** la plage de mesure des dispositifs de mesure du courant (4, 5 ; 4', 5') qui mesurent le courant de phase ($i_j$) à la même sortie du convertisseur statique (U) peut être permutée en alternance, de sorte que pendant la permutation de la plage de mesure d'un dispositif de mesure du courant (4, 5), au moins un autre dispositif de mesure du courant (4', 5') continue à mesurer le courant de phase ($i_j$).

13. Arrangement selon la revendication 12, **caractérisé en ce que** les dispositifs de mesure du courant (4, 5 ; 4', 5') au niveau desquels est respectivement mesuré ledit courant de phase ($i_j$) sont branchés en parallèle l'un à l'autre.

14. Arrangement selon la revendication 12 ou 13, configuré et conçu pour mettre en oeuvre le procédé selon l'une des revendications 1 à 11.

# FIG 1

# FIG 3

# FIG 2

FIG 4

**EP 2 824 464 B1**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 2012028390 A2
- JP 2005160136 A
- US 20060181289 A1
- WO 2012117275 A2
- DE 10240243 A1
- DE 10237920 B3